Europäisches Patentamt

(19) European Patent Office

Office européen des brevets

(11) Publication number: **0 221 657
B1**

(12) # EUROPEAN PATENT SPECIFICATION

(45) Date of publication of the patent specification:
19.12.90

(51) Int. Cl.⁵: **H01J 37/30, H01L 21/26**

(21) Application number: **86307213.8**

(22) Date of filing: **19.09.86**

(54) **Charged-particle-beam lithography.**

(30) Priority: **27.09.85 US 781403**

(43) Date of publication of application:
**13.05.87 Bulletin 87/20**

(45) Publication of the grant of the patent:
**19.12.90 Bulletin 90/51**

(84) Designated Contracting States:
**DE FR GB IT NL**

(56) References cited:
**EP-A- 0 056 179
DD-A- 216 137
DE-A- 3 034 598
GB-A- 1 483 171
US-A- 4 418 283**

(73) Proprietor: **AMERICAN TELEPHONE AND TELEGRAPH COMPANY, 550 Madison Avenue, New York, NY 10022(US)**

(72) Inventor: **Feldman, Martin, 141 Murray Hill Boulevard, Murray Hill New Jersey 07974(US)**
Inventor: **Lepselter, Martin Paul, 25 Sweetbriar Road, Summit New Jersey 07901(US)**

(74) Representative: **Johnston, Kenneth Graham et al, AT&T (UK) LTD. AT&T Intellectual Property Division 5 Mornington Road, Woodford Green Essex, IG8 OTU(GB)**

## Description

This invention relates to the fabrication of microminiature devices and, more particularly, to a charged-particle-beam lithographic method and apparatus adapted to directly write on a workpiece surface in a high-speed manner.

Various types of charged-particle-beam lithographic apparatus are known in the art. Such apparatus utilizing, for example, a single scanned electron beam has been widely used in the electronics industry as a practical tool for generating high-quality fine-featured integrated circuit masks.

Charged-particle-beam lithographic apparatus is also capable of exposing patterns directly on the surface of a workpiece such as a resist-coated semiconductor wafer. But, in practice, such direct-writing apparatus has not been widely accepted for commercial production because of the relatively long time required to write patterns on a large-area wafer.

A number of techniques have been suggested for increasing the writing speed of charged-particle-beam lithographic apparatus. Thus, for example, as described in U.S. Patent No. 4,393,312, the pattern-writing speed of such apparatus is increased by utilizing a mode of raster scanning in which the dimensions of a single writing spot are varied in a high-speed way during the scanning process. Other suggested ways of increasing writing speed involve expanding the output of a small-area source of charged particles by means of a linear or two-dimensional lens array to provide multiple writing spots, as described, for example, in U.S. Patent No. 4,153,843 and in "A Multiple-Electron-Beam Exposure System for High-Throughput, Direct-Write Submicrometer Lithography," by I. Brodie et al, IEEE Transactions on Electron Devices, Vol. ED-28, No. 11, November 1981, pages 1422–1428.

DD-A 216 137 discloses a lithographic system in which a plurality of electron beams are used to simultaneously expose a resist on a substrate. The system uses an optical reduction system to obtain beams of small cross section.

But none of the techniques suggested to date has in practice sufficiently increases writing speed to make charged-particle-beam lithographic apparatus economically attractive for general-purpose production use when operated in its direct-writing mode.

According to the present invention, there is provided apparatus as defined in claim 1.

In an embodiment of the invention, an elongated source of charged particles, for example, an electron-emitting hot wire, is utilized in conjunction with an apertured array to form multiple parallel electron beams. Focussing and individual modulation of the beams are carried out in the array. The array is linear and the width of the array of parallel beams provided thereby is comparable to the width of the wafer to be selectively irradiated. The entire surface of the wafer can thus be exposed in a single pass by sweeping the array of parallel beams across the wafer surface. During the single pass, the array of parallel beams selectively irradiates respective spaced-apart features on the surface. Features of variable length in the direction of the single pass are thereby defined. Irradiation of the surface to define orthogonally disposed features is accomplished, for example, by a magnetic deflection arrangement.

In other embodiments of the invention, an elongated p-n junction or multiple individual p-n junctions respectively associated with the apertures in the linear array are utilized as electron sources. In still other embodiments, electron-emitting photosensitive elements constitute the electron sources.

In one version of the apparatus, a magnetic field is utilized to image electrons from the source onto the linear array. In turn, the same magnetic field serves to project the focused output beams of electrons provided by the linear array onto the wafer surface.

FIG. 1 is a schematic generalized showing of a specific illustrative charged-particle-beam lithographic apparatus made in accordance with the principles of the present invention;

FIG. 2 is cross-sectional side view of a portion of the apparatus shown in FIG. 1;

FIG. 3 is a top view of a portion of the apertured array depicted in FIG. 2;

FIG. 4 is a cross-sectional enlargement of a portion of FIG. 3 as viewed in the direction of arrows IV of FIG. 3;

FIG. 5 is a schematic representation of an overall system including apparatus of the type illustrated in FIG. 1;

FIG. 6 shows a modified version of the FIG. 1 apparatus;

FIG. 7 depicts a two-dimensional array of beam-defining apertures suitable for inclusion in the apparatus described herein;

and FIGS. 8 and 9 each illustrate in simplified form a modification of FIG. 1 that includes another form of charged-particle emitter.

Lithographic apparatus made in accordance with applicants' inventive principles is designed to provide multiple parallel beams of charged particles at the surface of a workpiece such as a resist-coated semiconductor wafer. These charged-particle beams may comprise electrons or ions. Herein, for illustrative purposes, emphasis will be directed to electron beams. However, the inventive principles are applicable to apparatus in which ions rather than electrons are used.

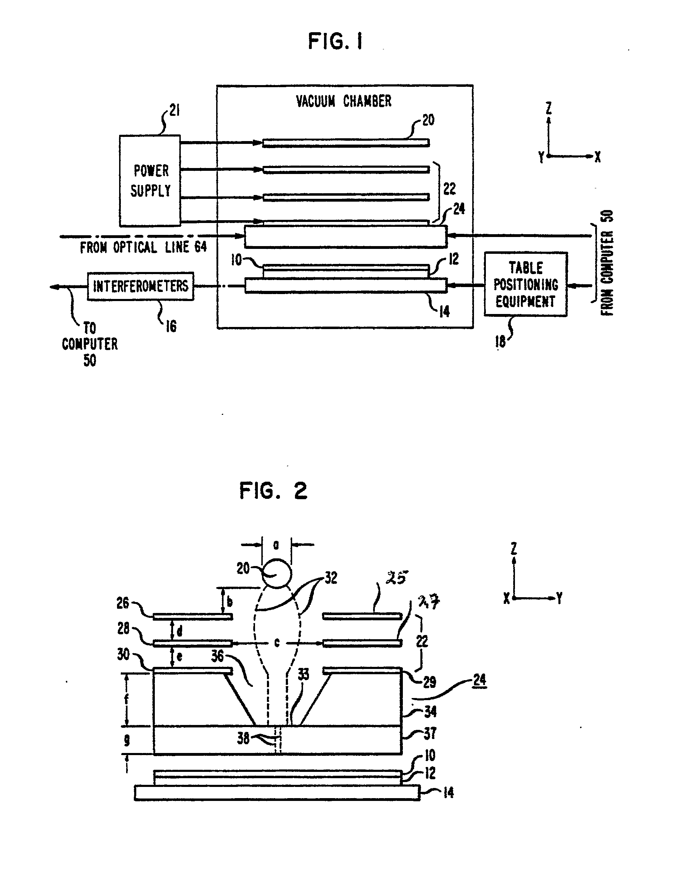

FIG. 1 shows a specific illustrative lithographic apparatus made in accordance with the principles of the present invention for controllably scanning multiple small-size parallel electron beams over the top surface of an electron-resist layer 10 deposited on a wafer 12. In turn, the wafer 12 is mounted on an X-Y-movable table 14.

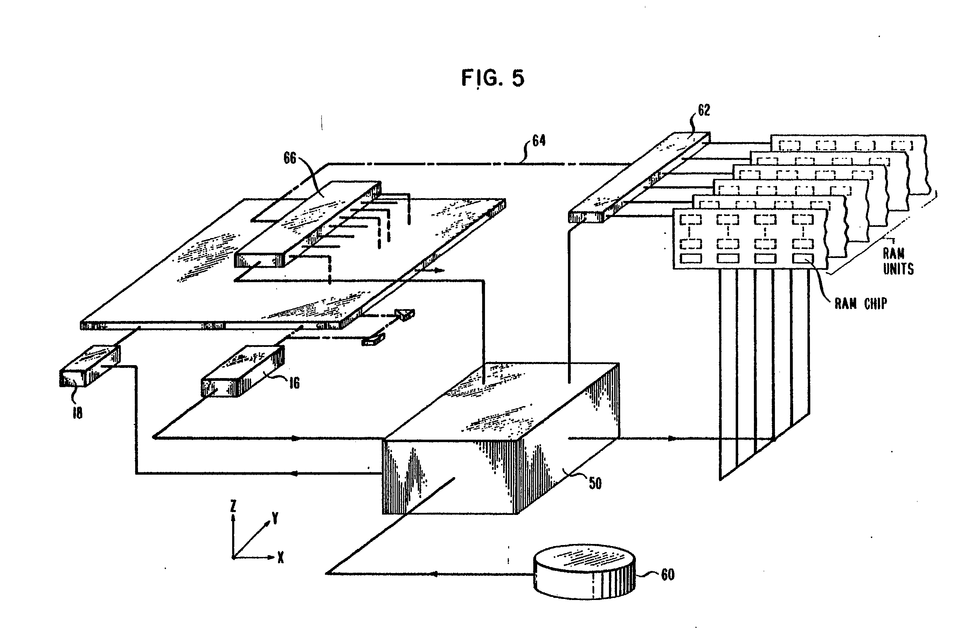

Conventional interferometers 16 and table-positioning equipment 18 of FIG. 1 are associated with the table 14. The interferometers 16 serve to accurately monitor table position in the X-Y plane and to supply signals indicative thereof to a control computer 50 shown in FIG. 5. The equipment 18 of FIG. 1 is mechanically coupled to the table 14 and responds to signals from the computer 50 by moving the table 14 in a prescribed manner. As will be described in detail later below, the main movement of the table 14 is controlled to occur in the Y direction.

In the illustrative FIG. 1 apparatus, electrons are supplied by an elongated wire element 20. The element 20 is connected to power supply 21 which, for example, causes a constant d-c current to flow through the element to cause it to be heated to a relatively high temperature, for instance, to about 1500 degrees Celsius, at which temperature electrons are emitted. Additionally, the element 20 is connected to a point of reference potential such as ground.

By way of example, the element 20 shown in FIG. 1 comprises a taut wire made of tungsten or of irridium impregnated with a suitable work-function-reducing material. In one specific embodiment, the element 20 comprises a round wire about 50 micrometers (μm) in diameter coated with thorium.

In accordance with the principles of the present invention, the electron-emitting element 20 (FIG. 1) is relatively long. In one advantageous embodiment, the extent of the element 20 in the X direction is at least equal to the entire X-direction width of the layer 10 to be selectively exposed. In such an embodiment, the entire surface of the layer 10 can be written in a single complete Y-direction excursion or pass of the table 14. Thus, for example, if the resist-coated wafer 12 is 15.24 centimeters (cm) wide in the X direction, the X-direction length of the element 20 is also at least 15.24 cm.

In other embodiments of applicants' invention, the length of the elongated element 20 (FIG. 1) is designed to be less than the entire X-direction width of the wafer 12. In such cases, more than one Y-direction excursion or pass of the table 14 is needed to completely expose the layer 10 utilizing multiple parallel beams. But in every case, whether single-pass or plural-pass operation is selected, the length of the element 20 included in applicants' inventive apparatus is co-extensive with the width of that portion of the wafer that is exposed by multiple beams during each pass.

Electrons emitted by the elongated wire element 20 of FIG. 1 are focused by, for example, an electrostatic lens assembly 22 that comprises three pairs of spaced-apart conductive plates. Downstream of the bottom pair of plates, the focused electrons comprise a beam whose X-direction extent corresponds to the length of the element 20 and whose Y-direction dimension is, for example, approximately 30 μm. In turn, this long narrow beam impinges on the top of an apertured beam-forming, focusing and blanking assembly 24 which is described in detail below.

The aforementioned electrostatic lens assembly 22 is also depicted in FIG. 2. The assembly 22 comprises a top pair of plates 25 and 26, a middle pair of plates 27 and 28, and a bottom pair of plates 29 and 30. Illustratively, each of the plates 25 and 26 is established at +10 volts with respect to the above-specified point of reference potential to which the element 20 is connected, each of the plates 27 and 28 is at +25 volts, and each of the plates 29 and 30 is at +50 volts. By way of example, the dimensions a, b, c, d, e, f and g indicated in FIG. 2 are approximately 50 μm, 75 μm, 125 μm, 75 μm, 75 μm, 500 μm and 9.6 μm, respectively. In the illustrative depicted embodiment, the plates 29 and 30 are mounted directly on the uppermost top surface of the assembly 24. The plates 25 through 30 are, for example, each about 75 μm thick.

The focusing action of the electrostatic lens assembly 22 of FIG. 2 is schematically represented by dash lines 32 which outline the envelope of the resulting electron beam that propagates between the emitting element 20 and the indicated top surface 33 of the beam-forming, focusing and blanking assembly 24. As it impinges upon the indicated top surface of the assembly 24, the electron beam is highly collimated and approximately perendicular to the top surface of the assembly 24. As previously mentioned, the Y-direction extent of the beam at the point at which it meets the indicated top surface of the assembly 24 is approximately 30 μm. Illustratively, the current density of the beam at that point is about 1.0 ampere per square centimeter.

The assembly 24 (FIG. 2) comprises a main support member 34 made, for example, of silicon. Illustratively, the member 34 has an elongated X-direction groove 36 formed therein. The length of the groove 36 corresponds approximately to the X-direction extent of the element 20. A subassembly 37 having a number of apertures therethrough is formed on the bottom surface of the member 34. One such aperture is represented in FIG. 2 by dash lines 38.

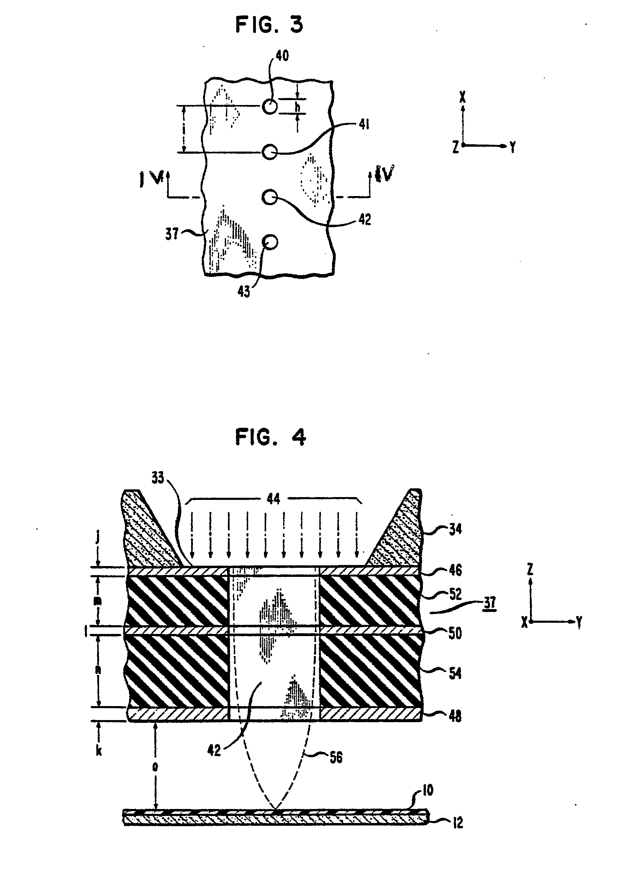

A top view of a portion of the subassembly 37, as viewed from the emitting element 20, is shown in FIG. 3. Four equally spaced-apart apertures 40 through 43 are indicated in the depicted portion. In one particular illustrative embodiment, the apertures are cylindrical and each has a diameter $h$ of about 1 μm. The center-to-center distance $i$ between adjacent apertures is approximately 4 μm. Since, as noted above, the Y-direction extent of the electron beam on the surface 33 is about 30 μm, only a relatively uniform and well-collimated central part of the incident beam actually enters the apertures included in the subassembly 37. Importantly, each individual aperture is associated with a respective portion of the filament 20, the length of each such filament portion being approximately equal to the diameter of its associated aperture.

FIG. 4 shows the aperture 42 of FIG. 3 formed in the subassembly 37. Electrons incident on the top surface 33 of the subassembly 37 are represented by dash lines 44. Importantly, because of the small volume of each aperture, few electrons are present therein at any time and space-charge limits on current are minimal.

For each aperture through the subassembly 37 shown in FIG. 4, there is provided an individual top electrode 46, surrounding the entrance of the aperture 42, an individual, aperture surrounding bottom electrode 48, and an individual, aperture surrounding gating electrode 50. By "individual" is meant that the electrodes surrounding each aperture are not connected to the electrodes surrounding the other apertures, hence each aperture can be individually electrically addressed and controlled. By way of example, the electrodes 46, 48 and 50 each comprise a conductive layer of doped polysilicon. Intermediate insulating layers 52 and 54 in the depicted subassembly 37 are made, for example, of silicone dioxide. Illustratively, the thicknesses $j$, $k$, $l$, $m$ and $n$ of the layers 46, 48, 50, 52 and 54 are approximately 0.2 μm, 2 μm, 0.4 μm, 1 μm and 6 μm, respectively.

Advantageously, the subassembly 37 of FIG. 4 is fabricated utilizing integrated-circuit fabrication techniques. In that way, it is feasible to make a highly precise structure having closely spaced-apart micron-size apertures having relatively high aspect ratios.

Each of the apertures such as the aperture 42 (FIG. 4) in the subassembly 37 is individually controlled to transmit or not transmit to the resist layer 10 that portion of the overall electron beam that enters the top of the aperture. This so-called blanking action is controlled by the gating electrode 50. Illustratively, the potential applied to the electrode 50 and to each of the other gating electrodes in the apertured assembly 24 is either -100 volts or +400 volts. In the first case (-100 volts), electrons that enter the top of the aperture 42 are prevented from propagating toward and out of the bottom thereof. In the second case (+400 volts), an electron beam is permitted to exit from the bottom of the aperture. (In alternative arrangements, pairs of spaced-apart gating electrodes at either side of the apertures are effective to accomplish blanking by deflecting electons sideways).

The potentials applied to the top and bottom electrodes 46 and 48 of the aperture 42 included in the subassembly 36 shown in FIG. 4 are, for example, approximately +400 volts and +2500 volts, respectively. The electric fields established thereby in the aperture 42 and in each of the other apertures serve to focus each nonblanked beam onto a specified plane beneath of the subassembly 37. In the particular case illustrated in FIG. 4, the electron beam represented by dash-line envelope 56 is shown being brought to a focus at the surface of the resist-coated wafer 12 which, for example, is maintained at a potential of about +2500 volts. Illustratively, the diameter of the focused beam at the surface of the wafer is approximately 0.25 μm. In that case, the separation $o$ between the bottom of the subassembly 37 and the surface of the resist-coated wafer 12 is about 4 μm.

By selectively varying the potentials applied to the electrodes around each aperture such as the aperture 42 of FIG. 4, the location of the focal plane of the beam transmitted therethrough can be varied. The diameter of the focused beam at the workpiece surface can thus be varied resulting in the capacity for selectively varying the width of the workpiece surface areas exposed to the electron beams.

Electrons that impinge upon and collect on the interior sidewalls of the apertures such as the aperture 42 (FIG. 4) may in time cause undesirable electric fields to be established in the apparatus. One advantageous way of avoiding such effects is to form a thin coating of a relatively high-resistivity material on selected portions of the aperture sidewalls. In turn, the coatings are electrically connected to the aforementioned electrodes 46, 48 and 50. This will provide a leakage path for electrons. Materials such as silicon nitride or boron nitride are suitable for this purpose.

In one particular illustrative embodiment of applicants' invention, approximately 38,100 apertures each of the type depicted in FIG. 4 are arranged in an X-direction linear array in the subassembly 37.

Accordingly, as many as that number of electron beams can be scanned in unison along spaced-apart parallel paths in the Y direction on the surface of the resist-coated wafer 12 across the full X-direction width thereof. During such a single-pass scan, each beam associated with an aperture is blanked or not at each Y-direction address position, depending on the valve of the control voltage applied to the gating electrode in each aperture.

The data processing requirements in a single-pass scanning system of the type described above are formidable. For that reason in particular, it is often advantageous to accomplish the Y-direction scanning in several less-than-full-wafer-width passes. After each such pass, the table 14 is stepped in the X direction and then another scan abutting the immediately prior one is carried out.

In one such illustrative multiple-pass system, the length of the electron-emitting element 20 is only about 1 cm. Thus, for a 15.24-cm-wide wafer, about fifteen successive abutting passes are required to expose substantially the entire wafer. In that case, the output of the 1-cm-long element 20 is focused onto the top surface 33 of the subassembly 37 (see FIG. 2) to provide an electron beam that encompasses a linear array of about 2500 apertures (assuming the same aperture-to-aperture spacing specified earlier above).

The data processing and information transfer operations of an overall lithographic system made in accordance with the principles of the present invention are schematically represented in simplified form in FIG. 5. Coordinate information representative of one level to be exposed on a resist-coated wafer is stored in a disk 60. Assuming multiple 1-cm-wide scans of the particular type mentioned above, and further assuming that repetitive 1 cm-by-1 cm pattern areas are to be exposed on the resist-coated wafer with an address structure of 0.5 μm, the disk 60 stores approximately $4 \times 10^8$ bits per level.

The information stored in the disk 60 of FIG. 5 is extracted therefrom by the computer 50 and applied to a parallel array of multiple RAM (random-access-memory) units each of which contains multiple 1-megabit RAM chips. In turn, the information transferred to the RAM units by the computer 50 is multiplexed in a standard unit 62 and then applied in serial form to a high-speed transmission line such as an optical data link 64. Advantageously, the end of the link 64 terminates directly on the assembly 24, as schematically indicated in FIG. 1. Illustratively, the assembly 24 includes a standard photodetector (not shown) coupled to the end of the link 64. In turn, the electrical output of the photodetector is applied to a conventional demultiplexer 66 (FIG. 5). Both the demultiplexer 66 and associated microminiature interconnects or leads emanating therefrom and extending to the aforementioned gating electrodes in the above-described apertures are advantageously fabricated in integrated-circuit form on portions of the silicon member 34 (FIG. 2) utilizing conventional semiconductor processing techniques. In that way, it is feasible to provide a low-cost highly integrated compact assembly including complex circuitry and thousands of individual leads.

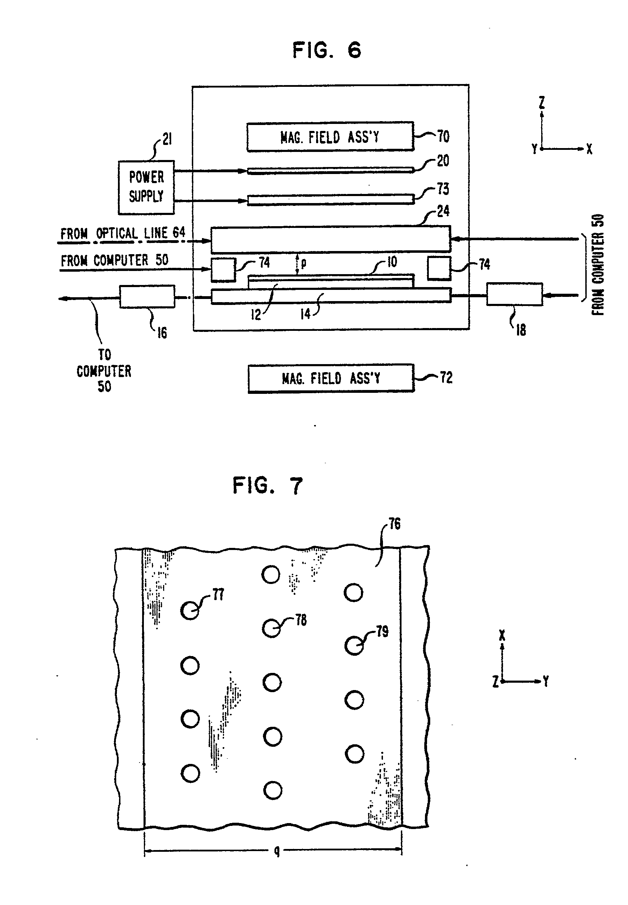

In some cases, the relatively small spacing described above as existing between the bottom of the assembly 24 (FIG. 1) and the top of the resist-coated wafer 12 may present practical difficulties. A larger spacing may be desired to facilitate holding the wafer on the table 14 and to make it easier during lithography to perform such standard functions as alignment and focus tracking. An illustrative system that is characterized by such a larger spacing is described below in connection with FIG. 6.

Additionally, to the point so far described, the apparatus exposes multiple spaced-apart elongated regions of variable widths. In practice, it is generally preferable to be able to selectively expose portions of the workpiece between the scanned regions. Various ways of accomplishing this, including one particularly advantageous way illustrated in FIG. 6, are now described.

The illustrative system represented in FIG. 6 is a modification of the FIG. 1 system. Identical elements in the two systems are designated with the same respective reference numerals.

Additional elements in the FIG. 6 system include a magnetic field assembly 70, 72 which comprises, for example, two spaced-apart coils. When energized, these coils establish a substantially uniform magnetic field therebetween whose lines of force extend parallel to the Z direction. Alternatively, the assembly 70, 72 may comprise the respective pole pieces of an integral permanent-magnet assembly. (The table 14 may even be designed to constitute one pole piece of such a permanent-magnet assembly, if care is taken to prevent eddy currents from forming in nearby conductors.)

The purpose of the magnetic assembly 70, 72 of FIG. 6 is two-fold. First, the assembly serves to perform magnetic imaging of electrons emitted by the wire element 20. In that way, a long narrow collimated beam of electrons is imaged onto the top of the linear array of apertures included in the assembly 24. Low-voltage operation of the assembly 24 and a field-free region at the workpiece surface are characteristics of the FIG. 6 system.

Since imaging is accomplished by the magnetic field assembly 70, 72 in the space between the element 20 and the top of the assembly 24 of FIG. 6, the electrostatic lens assembly 22 shown in FIG. 1 is not needed in that space. But a conductive plate 73 having an elongated X-direction slit therethrough is shown in FIG. 6 in the element 20-to-assembly 24 space. Illustratively, the plate 73 is established at a potential of about +10,000 volts with respect to the element 20 and serves as an accelerating and beam-forming electrode in the system. Additionally, the plate 73 serves as an effective thermal shield between the hot element 20 and the assembly 24.

Importantly, the magnetic assembly 70, 72 shown in FIG. 6 also serves to project focused beams emanating from the bottom of the assembly 24 onto the surface of the resist-coated wafer 12. In other words, the assembly 70, 72 functions to transfer to the workpiece surface whatever focus is formed by the assembly 24. In practice, this allows a larger spacing between the bottom of the assembly 24 and the workpiece surface than if focusing on the surface were carried out only by the assembly 24. In one particular embodiment, the spacing $p$ indicated in FIG. 6 is thereby permitted to be approximately 5 millimeters. In that embodiment, focussed 0.5-μm-diameter beams provided by the assembly 24 are transferred onto the surface of the resist-coated workpiece in a relatively sharply focused manner because although sidewise momentum effects cause the electrostatic focus to spread, they do not so affect the magnetic focusing action.

FIG. 6 also shows an advantageous instumentality for accomplishing X-direction movement of the beams during the main Y-direction scan. This is carried out by magnetic assembly 74 which, when energized, serves to accomplish high-speed X-direction deflection of any beam propagating downward in the space between the assembly 24 and the top of the resist-coated wafer 12. In that way, any specified portion of the regions between the elongated regions formed during the Y-direction scans can be selectively exposed during each main scan while the table 14 is moving.

Still other ways are available for accomplishing the aforespecified exposure in the regions between spaced-apart Y-direction scans. Thus, for example, successive interleaved Y-direction scans can be effectively employed to fill in these regions. Or, during each main Y-direction scan, high-speed mechanical movement of the table 14 by means, for example, of a piezoelectric transducer can be utilized to fill in laterally disposed regions of the surface to be exposed. Alternatively, in some cases it is feasible to purposely slightly defocus the beams emanating from the assembly 24 such that adjacent beams abut or overlap on the workpiece surface during the main Y-direction scan.

Another way involves a modified version of the assembly 24. In the modified version, a top view of which is schematically illustrated in FIG. 7, parallel rows of off-set apertures are included in an assembly 76 which is designed to replace the previously described assembly 24 shown in FIGS. 1, 2 and 3 that includes only a single elongated row of apertures. Each of the apertures in the assembly 76 also contains top and bottom electrodes and an individually controlled gating electrode, as previously described above for the assembly 24.

Illustratively, the width q of the flat top surface of the assembly 76 shown in FIG. 7 is approximately 18 μm. In practice, the entire extent of this flat surface is thus irradiated with collimated electrons emanating from the overlying X-direction-extending element 20 and defined by associated beam-forming components. By blanking or not blanking selected apertures in the assembly 76 as the underlying workpiece surface moves in the Y direction, it is thus possible to expose both Y-direction and X-direction strips on the workpiece.

More specifically, as is evident from FIG. 7, it is possible to selectively expose an X-direction strip by sequentially applying control voltages to the gating electrodes respectively included in apertures 77 through 79. Thus, for example, as a first surface region exposed by a beam that propagated through the aperture 77 reaches a point immediately above the aperture 78, the gating electrode associated with the aperture 78 can be controlled to momentarily permit the beam defined by the aperture 78 to impinge upon the workpiece surface. This causes exposure of a second X-displaced region abutting the first region. Similarly, later sequential control of the gating electode associated with the aperture 79 can be effective to momentarily expose a third X-displaced region abutting the second region. By following such a blanking strategy over the entire array of off-set apertures, X-extending regions of the workpiece surface can be selectively exposed during each Y-direction movement of the workpiece under control of the computer 50.

Elongated electron emitters other than the particular wire element 20 described above can be utilized in charged-particle-beam lithographic system. Thus, for example, standard forward-biased or reverse-biased silicon diodes or triodes including p-n junctions or metal-to-semiconductor junctions are attractive substitutes for the element 20. Illustratively, a single elongated such device may be employed as a direct replacement for the element 20. Or a linear array comprising multiple such electron-emitting devices respectively aligned with apertures in the assembly is feasible. The advantage of the latter arrangement is that the devices may be individually controlled to be emitting or not. In that case, individual gating electrodes in the apertures are not required.

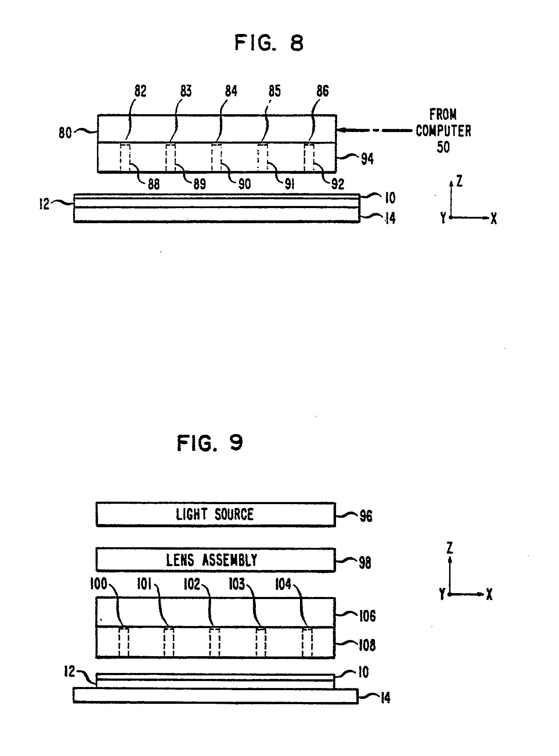

A portion of a particularly advantageous lithographic apparatus including individual electron-emitting devices of the type specified immediately above is schematically represented in FIG. 8. As indicated there, a silicon member 80 includes individual p-n junction devices 82 through 86 positioned at the respective tops of beam-focusing apertures 88 through 92 formed in subassembly 94. Each aperture includes individual top and bottom electrodes (not shown) of the type described above in connection with FIG. 4.

The individual electron-emitting devices 82 through 86 represented in FIG. 8 are respectively controlled to be in their emitting or non-emitting states by signals applied to the devices from the aforementioned computer 50. It is advantageous to form demultiplexing circuitry and connections to the respective emitting devices in the member 80 by utilizing standard integrated-circuit fabrication techniques thereby to form a highly compact integral structure characterized by low cost and excellent reliability.

Additionally, as shown in FIG. 9, photosensitive electron emitters can be used.

The FIG. 9 apparatus includes a light source 96 and an associated lens assembly 98. Together, these conventional elements serve to project an elongated X-direction line of light onto standard photosensitive electron emitters 100 through 104 formed on the bottom surface of a light-transparent block 106. In turn, each emitter is located at the top of a respective aperture defined in subassembly 108. By means of top, bottom and gating electrodes (not shown in FIG. 9) each electron beam emanating from an emitter is blanked or not. Also, each beam that is permitted to propagate toward the resist-coated wafer 12 is focused, in the same manner described earlier above.

Alternatively, the source 96 shown in FIG. 9 may include multiple individual light sources respectively associated with the photosensitive emitters 100 through 104. In that case, the output of each light source is focused by the assembly 98 to impinge upon its respective emitter. In some instances, it may be advantageous to individually control the multiple light sources to be ON or OFF. Or the emitters 100 through 104 may be individually electrically biased to be responsive or not to light impinging thereon. In either of these latter cases, gating electrodes are not required in the apertures in the subassembly 108.

Further modifications are possible. For example, although the emphasis hereinabove has been directed to apparatus in which the multiple beams remain stationary relative to an X-Y-movable table, it is practicable to maintain the table stationary and to move the entire beam-forming assembly relative thereto. This is feasible and even in some cases attractive because in practice beam-forming assemblies can be relatively small and light and easily controlled to move in a reliable high-speed manner. Additionally, particularly in embodiments of the type illustrated in FIGS. 8 and 9, the entire particle-emitting apparatus need not be included within a vacuum chamber. Thus, for example, standard differential pumping techniques may be employed to selectively establish the required vaccum conditions only in the immediate vicinity of those portions of the space between the apertured assembly and the workpiece surface where particles propagate between the assembly and the workpiece surface. Further, selective deflection of an elongated X-direction line of light may be advantageously applied to apparatus that includes rows of apertures each including photosensitive emitters.

**Claims**

1. Lithographic apparatus for producing a selected plurality of charged particle beams (56) for simultaneously exposing features on the surface (10) of a workpiece (12), said apparatus comprising elongated particle emitting means (20; 100–104; 82–86) for producing an elongated arrangement (44) of charged particles, and means (24) for causing selected charged particles to be formed into the said selected plurality of beams to be simultaneously directed to the workpiece, characterised in that the said means for causing selected charged particles to be formed into the said selected plurality of beams to be simultaneously directed to the workpiece comprises an assembly (37) with a plurality of apertures (42) in the path of said elongated arrangement of charged particles, said apertures being of the order of the sizes of the said features, and means for preventing charged particles from exiting certain selected ones of the apertures and for permitting charged particles to exit as beams from others of the apertures, and in that each beam extends through a respective aperture longitudinally to a focal plane (10) directly beneath the aperture.

2. Apparatus as in claim 1, further including means (18) for scanning said beams in unison across said workpiece surface in a specified direction.

3. Apparatus as in claim 2, wherein the extent of said beams in a direction orthogonal to said specified direction is approximately coextensive with the overall width of said workpiece surface.

4. Apparatus as in claim 2, wherein the apertures are arranged in at least one row disposed in the path of particles from said elongated source to permit particles that pass through said apertures to impinge upon said workpiece surface, said row being orthogonal to said specified direction.

5. Apparatus as in claim 4 wherein said elongated particle source is spaced apart from the entrances of said apertures.

6. Apparatus as in claim 5 further including means (22) for focusing particles from said source and directing said particles into said apertures.

7. Apparatus as in claim 6 further including means (46, 48) associated with each aperture for electrostatically focusing particles propagated therethrough.

8. Apparatus as in claim 7 further including gating means (50) associated with each aperture.

9. Apparatus as in claim 6 wherein said focusing and directing means comprises means (70, 72) for establishing magnetic field lines in the space between said source and the apertures.

10. Apparatus as in claim 9 wherein said focusing and directing means further comprises accelerating electrode means (73) in the space between said source and said elongated apertured means.

11. Apparatus as in claim 4 further including means (74) for causing said beams to impinge upon selected surface portions of said workpiece between the regions scanned by the beams in said specified scanning direction.

12. Apparatus as in claim 11 wherein said impinging means comprises means for periodically establishing magnetic lines of force parallel to the surface of said workpiece in a direction orthogonal to said specified scanning direction to cause beams emanating from said apertures to be deflected to said selected surface portions.

13. Apparatus as in claim 11 wherein said impinging means comprises multiple offset rows of apertures (77, 78, 79) in said elongated apertured means.

14. Apparatus as in claim 4 wherein said source comprises a semiconductor device having a single elongated p-n junction, and means for biasing said junction to emit particles.

15. Apparatus as in claim 4 wherein said source comprises an array of semiconductor devices associated on a one-to-one basis with said apertures, and means for individually switching on or off said devices.

16. Apparatus according to any preceding claim, wherein the assembly (37) with the apertures comprises a layered structure formed by semiconductor processing techniques.

## Patentansprüche

1. Lithographische Vorrichtung zur Erzeugung einer ausgewählten Vielzahl von Strahlen geladener Teilchen (56), die gleichzeitig Merkmale auf der Oberfläche (10) eines Werkstückes (12) bestrahlen, wobei die Vorrichtung aufweist:
längliche, Teilchen ausstrahlende Einrichtungen (20; 100–104; 82–86) zur Erzeugung einer länglichen Anordnung (44) geladener Teilchen, und
eine Einrichtung (24), die bewirkt, daß ausgewählte, geladene Teilchen der ausgewählten Vielzahl von Strahlen geformt und dann gleichzeitig auf das Werkstück gerichtet werden, dadurch gekennzeichnet,
daß die Einrichtung (24), die bewirkt, daß ausgewählte, geladene Teilchen der ausgewählten Vielzahl von Strahlen geformt und dann gleichzeitig auf das Werkstück gerichtet werden, aufweist:
eine Anordnung (37) mit einer Vielzahl von Öffnungen (42) in dem durch die längliche Anordnung geladener Teilchen gebildeten Weg, wobei die Öffnungen von der Größenordnung der Merkmale sind, und
eine Einrichtung, die geladene Teilchen am Austreten aus bestimmten ausgewählten Öffnungen hindert und geladenen Teilchen erlaubt, als Strahlen aus anderen Öffnungen auszutreten, und
daß sich jeder Strahl längs durch eine entsprechende Öffnung bis zu einer Brennebene (10) erstreckt, die unmittelbar unterhalb der Öffnung angeordnet ist.

2. Vorrichtung nach Anspruch 1 mit ferner einer Einrichtung (18) zur gleichmäßigen Abtastung der Werkstückoberfläche mittels der Strahlen in einer angegebenen Richtung.

3. Vorrichtung nach Anspruch 2, bei der die Ausdehnung der Strahlen rechtwinklig zur der angegebenen Richtung näherungsweise die gleiche Breite, wie die gesamte Breite der Werkstückoberfläche aufweist.

4. Vorrichtung nach Anspruch 2, bei der die Öffnungen in wenigstens einer Reihe liegen, die in dem Weg der von der länglichen Quelle emittierten Teilchen angeordnet ist und so den Teilchen ermöglicht, daß sie die Öffnungen durchlaufen und auf die Oberfläche des Werkstückes aufprallen, wobei die Reihe rechtwinklig zu der angegebenen Richtung liegt.

5. Vorrichtung nach Anspruch 4, bei der die längliche Teilchenquelle von den Eingängen der Öffnungen räumlich getrennt ist.

6. Vorrichtung nach Anspruch 5 mit ferner einer Einrichtung (22), die die von der Quelle kommenden Teilchen fokusiert und in die Öffnungen lenkt.

7. Vorrichtung nach Anspruch 6 mit ferner einer Einrichtung (46, 48), die jeder Öffnung zugeordnet ist, um die sich durch die jeweilige Öffnung ausbreitenden Teilchen elektrostatisch zu fokusieren.

8. Vorrichtung nach Anspruch 7 mit ferner einer jeder Öffnung zugeordneten Toreinrichtung (50).

9. Vorrichtung nach Anspruch 6, bei der die Fokusier- und Lenkeinrichtung eine Einrichtung (70, 72) enthält, die magnetische Feldlinien in dem Raum zwischen der Quelle und den Öffnungen aufbaut.

10. Vorrichtung nach Anspruch 9, bei der die Fokusier- und Lenkeinrichtung eine Beschleunigungselektrodeneinrichtung (73) in dem Raum zwischen der Quelle und der mit länglichen Öffnungen vorgesehenen Einrichtung enthält.

11. Vorrichtung nach Anspruch 4 mit ferner einer Einrichtung (74), die bewirkt, daß die Strahlen auf ausgewählte Oberflächenbereiche des Werkstückes zwischen den von den Strahlen in der angegebenen Abtastungsrichtung abgetasteten Bereiche aufprallen.

12. Vorrichtung nach Anspruch 11, bei der die Aufpralleinrichtung eine Einrichtung aufweist, die magnetische Kraftlinien periodisch aufbaut, die parallel zu der Oberfläche des Werkstückes und rechtwinklig zu der angegebenen Abtastrichtung verlaufen, und somit bewirken, daß aus den Öffnungen austretende Strahlen auf die ausgewählten Oberflächenbereiche abgelenkt werden.

13. Vorrichtung nach Anspruch 11, bei der die Aufpralleinrichtung mehrere gegeneinander versetzte Reihen von Öffnungen (77, 78, 79) in der mit länglichen Öffnungen versehenen Einrichtung enthält.

14. Vorrichtung nach Anspruch 4, bei der die Quelle ein Halbleiterbauelement mit einem einzelnen länglichen pn-Übergang und eine Einrichtung zur Vorspannung des Übergangs für ein Emittieren der Partikel enthält.

15. Vorrichtung nach Anspruch 4, bei der die Quelle ein Feld von Halbleiterbauelementen, die auf einer 1 zu 1 Grundlage den Öffnungen zugeordnet sind, und eine Einrichtung zum individuellen Ein- oder Ausschalten der Bauelemente enthält.

16. Vorrichtung nach einem der Ansprüche 1 bis 15, bei der die Anordnung (37) mit den Öffnungen eine geschichtete Struktur enthält, die mittels Herstellungstechniken für Halbleiter gebildet ist.

## Revendications

1. Appareil de lithographie destiné à produire un ensemble sélectionné de faisceaux de particules chargées (56), pour exposer simultanément des éléments sur la surface (10) d'un article (12), cet appareil comprenant des moyens d'émission de particules de forme allongée (20; 100–104; 82–86) destinés à produire une configuration allongée (44) de particules chargées; et des moyens (24) destinés à former avec des particules chargées sélectionnées l'ensemble de faisceaux sélectionné précité, devant être dirigés simultanément vers l'article, caractérisé en ce que les moyens destinés à former avec des particules chargées sélectionnées l'ensemble de faisceaux sélectionné précité devant être dirigés simultanément vers l'article, comprennent une structure (37) comportant un ensemble d'ouvertures (42) dans le chemin de la configuration allongée de particules chargées, ces ouvertures étant de l'ordre de grandeur des tailles des éléments précités, et des moyens pour empêcher que des particules chargées ne sortent par certaines ouvertures sélectionnées, et pour permettre à des particules chargées de sortir par d'autres ouvertures, sous la forme de faisceaux, et en ce que chaque faisceau traverse longitudinalement une ouverture respective en direction d'un plan focal (10) situé directement au-dessous de l'ouverture.

2. Appareil selon la revendication 1, comprenant en outre des moyens (18) destinés à communiquer aux faisceaux un mouvement de balayage conjoint sur la surface de l'article, dans une direction spécifiée.

3. Appareil selon la revendication 2, dans lequel l'étendue des faisceaux dans une direction orthogonale à la direction spécifiée coïncide approximativement avec la largeur globale de la surface de l'article.

4. Appareil selon la revendication 2, dans lequel les ouvertures sont disposées en au moins une rangée qui est placée dans le chemin de particules provenant de la source allongée, pour permettre à des particules qui traversent les ouvertures de tomber sur la surface de l'article, cette rangée étant orthogonale à la direction spécifiée.

5. Appareil selon la revendication 4, dans lequel la source de particules de forme allongée est espacée des entrées des ouvertures.

6. Appareil selon la revendication 5, comprenant en outre des moyens (22) pour focaliser des particules provenant de la source et pour diriger ces particules de façon qu'elles entrent dans les ouvertures.

7. Appareil selon la revendication 6, comprenant en outre des moyens (46, 48) associés à chaque ouverture pour focaliser de façon électrostatique des particules qui se propagent à travers les ouvertures.

8. Appareil selon la revendication 7, comprenant en outre des moyens de transmission sélective (50) associés à chaque ouverture.

9. Appareil selon la revendication 6, dans lequel les moyens de focalisation et de direction comprennent des moyens (70, 72) destinés à établir des lignes de champ magnétique dans l'espace compris entre la source et les ouvertures.

10. Appareil selon la revendication 9, dans lequel les moyens de focalisation et de direction comprennent en outre une électrode d'accélération (73) dans l'espace compris entre la source et les moyens allongés munis d'ouvertures.

11. Appareil selon la revendication 4, comprenant en outre des moyens (74) destinés à projeter les faisceaux de façon qu'ils tombent sur des parties de surface sélectionnées de l'article, entre les régions qui sont balayées par les faisceaux dans la direction de balayage spécifiée.

12. Appareil selon la revendication 11, dans lequel les moyens de projection comprennent des moyens destinés à établir périodiquement des lignes de force magnétiques parallèles à la surface de l'article, dans une direction orthogonale à la direction de balayage spécifiée, pour faire en sorte que des faisceaux qui émanent des ouvertures soient déviés vers les parties de surface spécifiées.

13. Appareil selon la revendication 11, dans lequel les moyens de projection comprennent des rangées d'ouvertures décalées multiples (77, 78, 79) dans les moyens allongés munis d'ouvertures.

14. Appareil selon la revendication 4, dans lequel la source comprend un dispositif à semiconducteurs ayant une seule jonction p-n allongée, et des moyens pour polariser la jonction de façon qu'elle émette des particules.

15. Appareil selon la revendication 4, dans lequel la source comprend un réseau de dispositifs à semiconducteurs associés un à un avec les ouvertures, et des moyens pour commuter individuellement ces dispositifs à l'état actif ou inactif.

16. Appareil selon l'une quelconque des revendications précédentes, dans lequel la structure (37) avec les ouvertures constitue une structure multicouche formée par des techniques de traitement de semiconducteurs.

FIG. I

FIG. 2

FIG. 3

FIG. 4

FIG. 5

EP 0 221 657 B1

## FIG. 6

## FIG. 7

## FIG. 8

80 ― 82 83 84 85 86 FROM COMPUTER 50

94

88 89 90 91 92

12 ― 10 14

Z
Y → X

## FIG. 9

| LIGHT SOURCE | 96 |

| LENS ASSEMBLY | 98 |

Z
Y → X

100 101 102 103 104 106

108

12 ― 10 14